# EUROPÄISCHE PATENTSCHRIFT

(11) **EP 1 097 482 B1**
(45) Veröffentlichungstag und Bekanntmachung des Hinweises auf die Patenterteilung: **21.09.2005**
(21) Anmeldenummer: 99947196.4
(22) Anmeldetag: 12.07.1999
(51) Int. Cl.: H01L 29/808

(54) **J-FET-HALBLEITERANORDNUNG**
J-FET SEMICONDUCTOR DEVICE
ENSEMBLE A SEMI-CONDUCTEUR, EN PARTICULIER TRANSISTOR A EFFET DE CHAMP A JONCTION

(30) Priorität: 23.07.1998 DE 19833214
(43) Veröffentlichungstag der Anmeldung: 09.05.2001
(73) Patentinhaber: SiCED Electronics Development GmbH & Co KG, 91052 Erlangen (DE)
(72) Erfinder: MITLEHNER, Heinz, D-91080 Uttenreuth (DE); WEINERT, Ulrich, D-91074 Herzogenaurach (DE)
(74) Vertreter: Berg, Peter
(86) Internationale Anmeldenummer: PCT/DE1999/002148
(87) Internationale Veröffentlichungsnummer: WO 2000/005768

(56) Entgegenhaltungen:
- EP-A- 0 522 938
- WO-A-97/23911
- DE-A- 19 629 088
- CAMPBELL P M ET AL: "TRAPEZOIDAL-GROOVE SCHOTTKY-GATE VERTICAL-CHANNEL GAAS FET (GAAS STATIC INDUCTION TRANSISTOR)" IEEE ELECTRON DEVICE LETTERS,US,IEEE INC. NEW YORK, Bd. EDL - 6, Nr. 6, Seite 304-306 XP000673827 ISSN: 0741-3106

## Beschreibung

Die Erfindung betrifft eine FET- Halbleiteranordnung und insbesondere eine vertikale J-FET- Halbleiteranordnung mit einem ersten Halbleitergebiet, das einen ersten Kontakt mit hochdotierter Kontaktschicht als Source zwischen zwei zweiten Kontakten als Gate an seiner ersten Oberfläche umfaßt.

In der Leistungsschalttechnik werden schnelle Schaltelemente mit möglichst niedrigen statischen und dynamischen Verlusten gesucht, die mit geringem Aufwand anzusteuern sind. Derartige Leistungsbauelemente kommen z.B. als DC-Schalter in Umrichtern für drehzahlveränderbare Antriebe oder als Wechselspannungsschalter (1- oder 3-phasig) von Motorabzweigen zum Einsatz. Die niedrige Verlustleistung ermöglicht kompakte Geräte mit hohem Wirkungsgrad.

Für Sperrspannungen von 600 V, 1200 V, 1800 V... werden heute meistens Silizium IGBT's mit einer Schwellspannung in Durchlaßrichtung eingesetzt.

Der Nachteil bei diesem Stand der Technik ist jedoch, daß es bei hoch dynamischen Motorsteuerungen mit bipolaren IGBT's zu einem Leistungsderating auf Grund der Schaltverluste kommt, die durch die bipolare Speicherladung verursacht werden.

Durch die Verwendung schneller, unipolarer Leistungs-MOSFET's aus Silizium werden die Schaltverluste zwar drastisch reduziert, aber die Durchlaßverluste bzw. der spezifische Einschaltwiderstand in den genannten Sperrspannungsbereichen sind beträchtlich, und die Chipflächen müssen groß gewählt werden, was höhere Kosten bedeutet und daher häufig den Ausschlag zugunsten des IGBT gibt.

Als verbesserte FETs dieser Art wurden von Tihany in *DE 43 09 764* C2 ein MOSFET in Si-Technologie und von Mitlehner et al. in *WO 97*/*23911* A1 (entspricht der Präambel des Anspruches 1) ein vertikaler J-FET vorgeschlagen, der insbesondere in SiC Technologie hergestellt werden kann. Der J-FET nach diesem Stand der Technik weist ein zweites Halbleitergebiet innerhalb eines ersten Halbleitergebietes unterhalb eines Kontaktes auf, wobei erstes und zweites Halbleitergebiet vom entgegengesetzten Leitfähigkeitstyp sind. Das zweite Halbleitergebiet dient der Abschirmung der Source gegenüber dem Drain und erstreckt sich in der Projektion auf die Oberfläche des Halbleiters über den Kontakt hinaus, so daß in dem ersten Halbleitergebiet wenigstens ein Kanalgebiet gebildet ist, das nach unten durch die Verarmungszone des zwischen dem ersten Halbleitergebiet und dem zweiten Halbleitergebiet gebildeten pn-Übergangs begrenzt ist und in einem Durchlaßzustand einen elektrischen Strom vom oder zum Kontakt transportiert.

Die zweiten Halbleitergebiete innerhalb des ersten Halbleitergebietes sind jedoch aufwendig in der Herstellung. Insbesondere ist die Herstellung der Bauelemente in SiC u. a. wegen dessen thermischer Eigenschaften schwierig: die Implantation muß sehr genau über den gesamten gewünschten Bereich des zweiten Halbleitergebietes erfolgen, da eine spätere Anpassung der Ausdehnung des zweiten Halbleitergebietes durch Diffusion in SiC nicht mehr möglich ist. Andererseits ist die Herstellung hoch sperrender Bauelemente in SiC interessant, da SiC eine gegenüber Si sehr hohe Durchbruchfeldstärke und sehr gute Durchlaßeigenschaften hat.

Aufgabe der vorliegenden Erfindung ist es, ein Schaltelement zu schaffen, das verlustarm, schnell und kurzschlußfest ist und das einfach und damit kostengünstig herzustellen ist. Dabei liegen die Sperrspannungen typischerweise im Bereich von 600 V, 1200 V, 1800 V.

Diese Aufgabe wird erfindungsgemäß gelöst durch eine vertikale J-FET-Halbleiteranordnung mit den Merkmalen nach Anspruch 1. Bevorzugte Ausführungsformen der Erfindung sind Gegenstand der Unteransprüche.

Erfindungsgemäß werden wenigstens einige der zweiten Halbleitergebiete nicht wie beim Stand der Technik als "Inseln" erzeugt, über denen dann eine weitere Epitaxieschicht angeordnet ist, sondern alle zweiten Halbleitergebiete werden als Bereiche an der Oberfläche des Bauelements erzeugt. Der erfindungsgemäße Aufbau des Halbleiterelements ist fertigungstechnisch sehr viel einfacher und ermöglicht damit eine besonders kostengünstige Herstellung des Bauelements aus schwierig handzuhabenden Materialien wie SiC.

Die erfindungsgemäße J-FET-Halbleiteranordnung ist dadurch gekennzeichnet, daß die drei Kontakte jeweils mit einem zweiten Halbleitergebiet verbunden sind, wobei as erste Halbleibergebiet und die zweiten Halbleitergebiete vom entgegengesetzten Leitfähigkeitstyp sind, und die jenigen zweiten Halbleitergebiete, die mit den zweiten Kontakten verbunden sind, sich im ersten Halbleitergebiet unterhalb des jenigen zweiten Halbleitergebietes, das mit dem ersten Kontakt verbunden ist, erstrecken, so daß sich in einer Projektion auf eine horizontale Ebene die drei zweiten Halbleitergebiete sich wenigstens teilweise überdecken und in dem ersten Halbleitergebiet wenigstens ein Kanalgebiet zwischen den drei zweiten Halbleitergebieten gebildet ist.

In einer bevorzugten Ausführungsform der Erfindung weist der erste Kontakt wenigstens eine Aussparung auf, so daß ein elektrischer Kontakt zwischen dem ersten Kontakt und dem zweiten Halbleitergebiet unter dem zweiten Kontakt besteht. Dadurch wird das Floaten des zweiten Halbleitergebietes vermieden.

In einer weiteren bevorzugten Ausführungsform wird eine dielektrische Passivierung des Bauelements vorgesehen, wobei die dielektrische Passivierungsschicht jeweils zwischen dem ersten Kontakt und dem zweiten Kontakt auf der Oberfläche des ersten Halbleitergebietes vorgesehen ist und entweder eine Oxidschicht oder eine Halbleiterschicht umfaßt, die derart dotiert ist, daß sie einen dem ersten Halbleitergebiet entgegengesetzten Leitfähigkeitstyp hat. Dadurch wird eine höhere Stabilität erreicht.

Ein Vorteil der Erfindung besteht darin, daß die Verlustleistung der erfindungsgemäßen J-FET-Halbleiteranordnung um ca. eine Größenordnung unter derjenigen heute üblicher Si-IGBTs in diesem Leistungsbereich liegt. Außerdem kann die Längenausdehnung des vertikalen Driftgebietes W_{ch vert} groß gewählt werden, da das zweite Halbleitergebiet unter der hochdotierten Kontaktschicht des ersten Kontakts (= Source) für die notwendige Abschirmung ohne Beeinträchtigung der Sperrspannung sorgt.

Ein weiterer Vorteil der Erfindung besteht darin, daß die Ausgangskapazität niedrig ist, da ein großflächiges zweites Halbleitergebiet an die hochdotierte Kontaktschicht des ersten Kontakts (= Source) angehängt ist. Damit wird auch eine weitere Absenkung der Schaltverluste erreicht, da das Umladen des zweiten Kontakts (= Gate) geringer ausfällt.

Des weiteren sind die statischen Verluste des erfindungsgemäßen J-FET besonders niedrig, da die Driftzone optimal ausgenutzt wird.

Weitere Merkmale und Vorteile der Erfindung ergeben sich aus der folgenden Beschreibung spezieller Ausführungsformen der Erfindung, wobei Bezug genommen wird auf die beigefügten Zeichnungen, bei denen
Figur 1 eine erste Ausführungsform der Erfindung zeigt,
Figur 2 eine zweite Ausführungsform der Erfindung zeigt.

Die Durchlaßverluste eines unipolaren Leistungsbauelementes sind neben den Substrat- und Kontaktwiderständen vor allem durch Kanal- und Driftwiderstand der die Spannung aufnehmenden, relativ niedrig dotierten n-Zone des Feldeffekttransistors bestimmt. Betrachtet man J-FET Strukturen als sogenannte normal eingeschaltete Bauelemente, die abschaltbar sind, oder J-FET's mit Niedervolt - MOSFET's in einer Kaskode kombiniert als normal abgeschaltete Bauelemente, so kann der Driftwiderstand und damit die Durchlaßverluste des J-FET'S dadurch reduziert werden, daß eine möglichst hohe Leitfähigkeit der Driftzone durch eine optimale Ausnutzung der Chipfläche für die Stromausbreitung erreicht wird.

Erfindungsgemäß wird dies dadurch erreicht, daß in diesen Teilgebieten die Abschirmung der Drainspannung vom Source-Gebiet so gestaltet wird, daß die Stromausbreitung in einem ersten n-dotierten Epitaxie-Gebiet minimal beeinträchtigt wird. Dies wird durch eine p-Implantation mit hoher Dosis entsprechend der Poissongleichung für das maximale Feld im entsprechenden Halbleitermaterial, hier vorzugsweise SiC, das direkt an das n⁺⁺-dotierte Source-Gebiet angekoppelt ist, erreicht. Bei Versuchsmessungen wurde mit einem solchen Aufbau bereits bei ca. 15 V die gesamte zweite Epitaxie-Zone unterhalb der Source ausgeräumt. Die laterale Ausdehnung des vertikalen Kanals W_{ch vert} kann dabei in einem sehr großen Intervall frei gewählt werden, da die p-Zone unter dem n⁺⁺-dotierten Sourcegebiet für die notwendige Abschirmung ohne Beeinträchtigung der Sperrspannung sorgt. Die Emittereffizienz des kleinflächigen Emitterrandes ist dabei - wie dem Fachmann allgemein bekannt - auch für hohe Ströme vollständig ausreichend.

Des weiteren kann mit dem erfindungsgemäßen Aufbau als ein besonderer Vorteil die Ausgangskapazität niedrig gehalten werden, da großflächige p-Gebiete an den n⁺⁺-dotierten Source-Eingang (kurzgeschlossen) angehängt sind. Daher bleiben auch die Schaltverluste niedrig, da die Umladung eines großflächigen Teils des Gates durch den Eingangslastkreis getragen werden.

Zur Erhöhung der Stabilität kann an den Seitenrändern der zweiten Epitaxie-Schicht, auf der sich der Source-Kontakt befindet, eine dielektrische Passivierung (z.B. aus SiO₂) oder eine weitere p-Implantation, die als pn-Isolation wirkt, vorgesehen werden.

Im folgenden werden diese Merkmale anhand zweier Ausführungsbeispiele näher erläutert. Dabei wird von einem n-dotierten Substrat ausgegangen. Die Erfindung ist jedoch nicht auf diesen Leitfähigkeitstyp eingeschränkt, und es ist selbstverständlich grundsätzlich möglich, alle Leitfähigkeitstypen, die in der Beschreibung genannt werden, entgegengesetzt zu wählen.

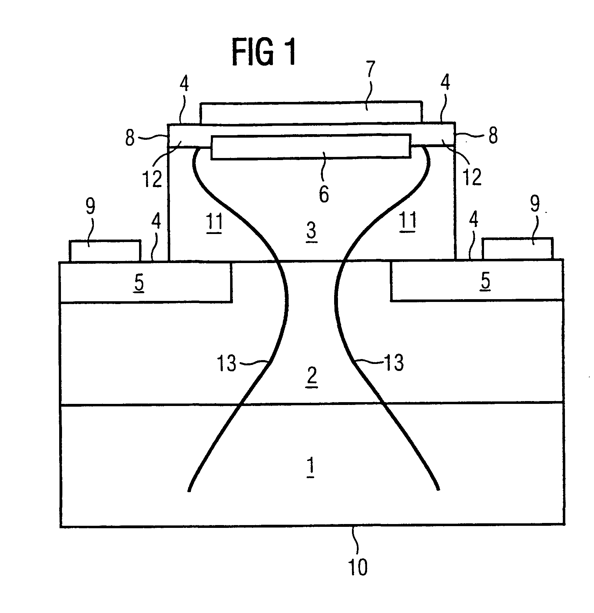

In Fig. 1 ist der erfindungsgemäße J-FET-Halbleiteraufbau aus SiC im Querschnitt dargestellt. Dabei bezeichnet 1 ein Substrat, auf dem die weiteren epitaxialen Schichten aufgebracht sind. Der Leitfähigkeitstyp des Substrats 1 ist in der gezeigten Ausführungsform der n-Typ. An der Unterseite des Substrats 1 befindet sich ein Drain-Kontakt 10, über den ein Strom durch das Substrat 1 abfließt.

Auf dem Substrat 1 ist ein erstes Halbleitergebiet als eine erste n-dotierte epitaxiale Schicht 2 aufgebracht. An der Oberfläche 4 der epitaxialen Schicht 2 sind Gate-Kontakte 9 angeordnet, über die der Widerstand im Driftgebiet, d. h. in dem ersten Halbleitergebiet von außen einstellbar ist. Die Gate-Kontakte 9 sind in gleicher Höhe angeordnet, und über die Spannung zwischen dem Gate-Kontakt 9 und einem Source-Kontakt 7 werden in dem Gebiet zwischen den beiden Gate-Kontakten 9 auf der gleichen Höhe die Ladungsträger ausgeräumt und damit der Driftwiderstand erhöht: der Transistor beginnt zu sperren.

Oberhalb der ersten epitaxialen Schicht 2 und zwischen den beiden Gate-Elektroden 9 ist bei der erfindungsgemäßen J-FET-Halbleiteranordnung eine weitere n-dotierte epitaxiale Schicht 3 aufgebracht, die eine Fortsetzung des ersten Halbleitergebietes darstellt, so daß sich ein zusammenhängendes erstes Halbleitergebiet 2 und 3 ergibt. Die freiliegende Oberfläche 4 der zweiten epitaxialen Schicht 3 ist stark, d.h. n⁺⁺-dotiert, so daß sich eine ohmsche Kontaktschicht 8 ergibt, die als Source dient und über die aus dem Source-Kontakt 7 Ladungsträger in den Halbleiter injiziert werden.

In Fig. 1 ist der Strompfad von der Source 7 zwischen den Gate-Kontakten 9 hindurch zum Drain 10 durch zwei Stromlinien 13 in dem Driftgebiet dargestellt.

Ein wesentliches Merkmal der Erfindung ist die Anordnung eines zweiten Halbleitergebietes 6 unmittelbar benachbart zu dem Source-Kontakt 7, das so dotiert ist, daß es gegenüber dem ersten Halbleitergebiet 2 vom entgegengesetzten Leitungstyp ist. Mit anderen Worten, direkt unter der Kontaktschicht 8 der Source wird erfindungsgemäß ein zweites Halbleitergebiet 6 als p-dotierte Insel implantiert. Dabei wird das gewünschte Dotierprofil durch das Eindringprofil bei der Ionenimplantation mittels Einstellung der Ionenenergie eingestellt.

Das zweite Halbleitergebiet 6 schirmt die Source 7 gegenüber dem Drain 10 ab. Die Fläche, die der p-dotierte Bereich 6 unter dem Source-Kontakt 7 abdeckt, ist vorzugsweise zentriert unter dem Kontakt 7. Damit aber der Stromfluß aus der Source 7 in den Halbleiter nicht übermäßig behindert wird, wird von dem p-dotierten Bereich die Kontaktschicht 8 nicht in ihrer gesamten lateralen Ausdehnung bedeckt, sondern es bleibt ein Randbereich der Kontaktschicht 8 frei. Über diesen Randbereich fließt Strom von dem Source-Kontakt 7 in den Halbleiter. Die Effizienz des Randes der Kontaktschicht 8 ist auch für hohe Ströme ausreichend und wurde bereits bei konventionellen Si-Ring-Emitter-Transistoren im Stand der Technik von der Anmelderin ausgenutzt.

Da über den Randbereich der n⁺⁺-Kontaktschicht 8 jedoch ein Durchgriff des Drains 10 auf die Source 7 möglich ist, werden unter den Gate-Kontakten 9 ebenfalls jeweils zweite Halbleitergebiete 5 als p-dotierte Gebiete implantiert, die sich seitlich entlang der Oberfläche 4 der ersten epitaxialen Schicht 2 in das erste Halbleitergebiet erstrecken. Insbesondere können diese p-dotierten Gebiete einen zusammenhängenden Bereich bilden, so daß von oben gesehen die Source 7 in einem "Ring", der durch das Gate 9 gebildet wird, "eingekreist" ist. Die geometrische Anordnung der p-dotierten Inseln in dem n-dotierten ersten Halbleitergebiet ist dabei so gewählt, daß sich die beiden zweiten Halbleitergebiete 5 unter den Gate-Kontakten 9 soweit in das erste Halbleitergebiet der ersten Epitaxieschicht 2 erstrecken, daß sie in einer Projektion auf eine Ebene, in der das zweite Halbleitergebiet 6 liegt, das mit der Source verbunden ist, das zweite Halbleitergebiet 6 wenigstens teilweise, d. h. insbesondere am Rand überlappen. Damit wird ein Durchgriff des Drains auf die Source minimiert und der Steuerkanal 11 mit der Ausdehnung W_{ch vert} definiert.

Zwischen den zweiten Halbleitergebieten 5 unter dem Gate 9 und 6 unter der Source 7 verläuft ein Kanalgebiet 11, das durch die Verarmungszone des zwischen dem ersten Halbleitergebiet und dem zweiten Halbleitergebiet gebildeten pn-Übergangs begrenzt ist. Der Stromfluß durch das Kanalgebiet 11 ist durch einige Stromlinien 13 angedeutet. Sie entspringen am Rand des Kontaktes 8 der Source neben der Abschirmung durch das zweite Halbleitergebiet 6 und verlaufen enger werdend zwischen dem zweiten Halbleitergebiet 5 am Gate 9 und dem zweiten Halbleitergebiet 6 an der Source 7 durch das erste Halbleitergebiet der zweiten Schicht 3. Unterhalb der zweiten Halbleitergebiete 5 des Gates wird die Stromdichte wieder geringer, d. h. die Stromlinien laufen auseinander.

Mit einer J-FET-Halbleiteranordnung nach Fig. 1 wird die verfügbare Fläche im Halbleiter zu einem hohen Grade zur Stromausbreitung ausgenutzt, ohne daß dadurch die Sperrspannung in den entscheidenden Teilgebieten oder die Abschirmung des Source-Gebietes gegen das Drainpotential beeinträchtigt wird.

Insbesondere in Umrichteranwendungen findet die Erfindung vorteilhafte Anwendungen. Bei Umrichteranwendungen müssen die schaltenden Bauelemente "normally off" betrieben werden, d.h. bei Stromausfall z.B. in der Gate-Ansteuerung sollen alle Schaltelemente automatisch in den sperrenden Zustand gelangen. Dies ist besonders einfach mit der erfindungsgemäßen hochsperrenden J-FET- Halbleiteranordnung möglich, indem eine Kaskodenschaltung realisiert wird, bei der ein Niedervolt-MOS-FET bzw. ein Niedervolt-SMART-FET vor den SiC-J-FET geschaltet wird, wobei der Niedervolt-FET jeweils in bekannter Si-Technologie hergestellt werden kann. Bei einer derartigen Kaskodenschaltung kann die Steuerung des hochsperrenden Halbleiterbauelements über den Si-MOSFET mit der gut beherrschten Si-Technik aufgebaut werden. Ein weiterer Vorteil eines vorgeschalteten Niedervolt-MOS-FET besteht darin, daß eine bei Wechselrichtern mit induktiver Last erforderliche Freilaufdiode eingespart wird, da die Built-in-Diode des Niedervolt-MOSFET's auch für die hohen Sperrspannungen der Kaskode als Freilaufdiode wirkt.

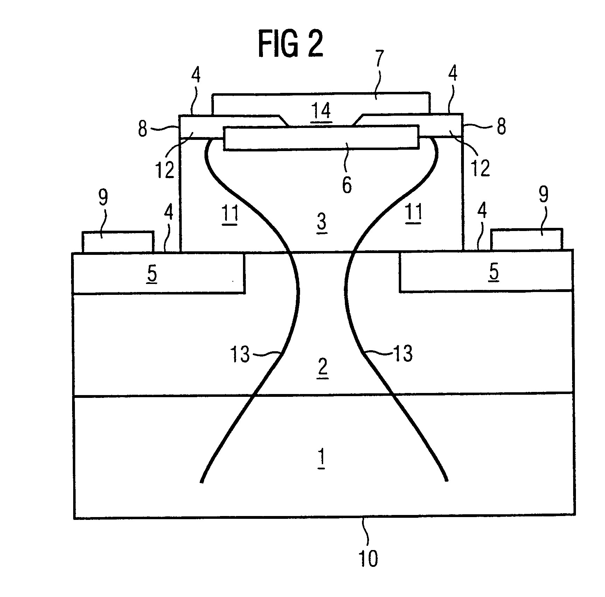

In einer weiteren Ausführungsform der Erfindung, die in Fig. 2 dargestellt ist, ist eine elektrische Verbindung zwischen der Source-Elektrode 7 und dem zweiten Halbleitergebiet 6 unter der Source vorgesehen. Dadurch wird das Potential des zweiten Halbleitergebietes 6 eindeutig definiert, und es wird das "Floaten" des zweiten Halbleitergebietes 6 vermieden: Die Kontaktierung wird durch eine Aussparung 14 in der n⁺⁺- Kontaktschicht 8 hergestellt, die mit einer Metallisierungsschicht aufgefüllt wird, die auch den Source-Kontakt 7 bildet, so daß die Source 7 mit der Insel 6 kurzgeschlossen wird. Neben der Ausführungsform mit nur einer einzelnen Aussparung 14 ist auch die Ausführung mit mehreren, kleineren Aussparungen möglich. In der Praxis wird die Wahl zwischen einer großen und mehreren kleineren bis hin zu einer porösen Beschaffenheit der n⁺⁺-Schicht 8 zwischen Source 7 und zweitem Halbleitergebiet 6 von den mechanischen und elektrischen Anforderungen bei der Herstellung des Bauelements bestimmt.

Die übrigen Gebiete in der Ausführungsform nach Fig. 2 entsprechen denen in Fig. 1 mit jeweils gleicher Bezugsziffer.

In einer weiteren (nicht dargestellten) Ausführungsform der Erfindung ist an den Seitenrändern der zweiten, mesa-ähnlichen Epitaxie-Schicht 3, auf der sich der Source-Kontakt 7 befindet, eine dielektrische Passivierung vorgesehen, die als pn-Isolation wirkt. Die dielektrische Passivierung dient der Erhöhung der Stabilität und kann aus SiO₂ bestehen oder eine dotierte Schicht sein, deren Leitfähigkeitstyp dem Leitfähigkeitstyp des ersten Halbleitergebietes entgegengesetzt ist.

Daß die Struktur der erfindungsgemäßen J-FET- Halbleiteranordnung leichter zu verwirklichen ist als eine Struktur mit implantierten "Inseln" in dem Substrat, eröffnet weitere und verbesserte Möglichkeiten, SiC als Halbleitermaterial für derartige Bauelemente zu verwenden. Damit ist eine höhere Sperrfähigkeit bei verbesserten Durchlaßeigenschaften erreichbar: Es lassen sich besonders niedrige statische Verluste realisieren, da die Driftzone bei dem erfindungsgemäßen Aufbau besonders gut genutzt wird.

Außerdem bleiben bei dem erfindungsgemäßen Aufbau des vertikalen J-FET die direkten Schaltverluste aufgrund der kleinen Gatekapazität niedrig. Auch läßt sich bei der erfindungsgemäßen Struktur der J-FET mit z.B. einem Niedervolt-SIPMOS in einer Kaskode kombinieren, so daß viele Steuer- und Kontrollfunktionen auf der 50 V Ebene mit dem erfindungsgemäßen Bauelement abgedeckt werden können.

Die vorgeschlagene Struktur eines vertikalen J-FET's in SiC läßt sich vorteilhaft nach einer (relativ flachen) Trenchätzung, so daß sich eine Höhe von ca. 2 µm zwischen dem Gate-Kontakt 9 und der Source 7 ergibt, am Gate "netzartig" kontaktieren, so daß eine hohe Zellendichte, d.h. hohe Materialausnutzung erzielt werden kann.

## Patentansprüche

1. Vertikale J-FET-Halbleiteranordnung mit einem ersten Halbleitergebiet (2, 3), das einen ersten Kontakt (7) mit hoch dotierter Kontaktschicht (8) als Source zwischen zwei zweiten Kontakten (9) als Gate an seiner ersten Oberfläche (4) umfaßt, wobei der erste Kontakt (7) und die zweiten Kontakte (9) jeweils mit einem zweiten Halbleitergebiet (5, 6) verbunden sind, wobei das erste Halbleitergebiet (2,3) und die zweiten Halbleitergebiete (5, 6) vom entgegengesetzten Leitfähigkeitstyp sind, **dadurch gekennzeichnet, daß** die jenigen zweiten Halbleitergebiete (5), die mit den zweiten Kontakten (9) verbunden sind, sich im ersten Halbleitergebiet (2, 3) unterhalb des jenigen zweiten Halbleitergebietes (6), das mit dem ersten Kontakt (7) verbunden ist, erstrecken, so daß in einer Projektion auf eine horizontale Ebene die drei zweiten Halbleitergebiete (5, 6) sich wenigstens teilweise überdecken und in dem ersten Halbleitergebiet (2, 3) wenigstens ein Kanalgebiet (11) zwischen den drei zweiten Halbleitergebieten (5, 6) gebildet ist.

2. Vertikale J-FET-Halbleiteranordnung nach Anspruch 1,
**dadurch gekennzeichnet, daß** die Kontaktschicht (8) wenigstens eine Aussparung (14) aufweist, so daß ein elektrischer Kontakt zwischen dem ersten Kontakt (7) und dem zweiten Halbleitergebiet (6) unter dem zweiten Kontakt (7) besteht.

3. Vertikale J-FET-Halbleiteranordnung nach einem der vorangehenden Ansprüche, **gekennzeichnet durch** eine dielektrische Passivierungsschicht jeweils zwischen dem ersten Kontakt (7) und dem zweiten Kontakt (9) auf der Oberfläche (4) des ersten Halbleitergebietes.

4. Vertikale J-FET-Halbleiteranordnung nach Anspruch 3,
**dadurch gekennzeichnet, daß** die Passivierungsschicht eine Oxidschicht umfaßt.

5. Vertikale J-FET-Halbleiteranordnung nach Anspruch 3,
**dadurch gekennzeichnet, daß** die Passivierungsschicht eine Halbleiterschicht umfaßt, die derart dotiert ist, daß sie einen dem ersten Halbleitergebiet entgegengesetzten Leitfähigkeitstyp hat.

6. Vertikale J-FET-Halbleiteranordnung nach einem der vorangehenden Ansprüche, **dadurch gekennzeichnet, daß** das Halbleitergebiet aus SiC hergestellt ist.

## Claims

1. Vertical J-FET semiconductor arrangement having a first semiconductor region (2, 3), which comprises a first contact (7) with a highly doped contact layer (8) as source between two second contacts (9) as gate on its first surface (4), the first contact (7) and the second contact (9) each being connected to a second semiconductor region (5, 6), the first semiconductor region (2, 3) and the second semiconductor regions (5, 6) being of opposite conductivity types, **characterized in that** those second semiconductor regions (5) connected to the second contacts (9) extend in the first semiconductor region (2, 3) below that second semiconductor region (6) connected to the first contact (7), with the result that the three second semiconductor regions (5, 6) at least partially overlap in a projection onto a horizontal plane and at least one channel region (11) is formed between the three second semiconductor regions (5, 6) in the first semiconductor region (2, 3).

2. Vertical J-FET semiconductor arrangement according to Claim 1, **characterized in that** the contact layer (8) has at least one cutout (14), so that there is an electrical contact between the first contact (7) and the second semiconductor region (6) under the second contact (7).

3. Vertical J-FET semiconductor arrangement according to one of the preceding claims, **characterized by** a dielectric passivation layer in each case between the first contact (7) and the second contact (9) on the surface (4) of the first semiconductor region.

4. Vertical J-FET semiconductor arrangement according to Claim 3, **characterized in that** the passivation layer comprises an oxide layer.

5. Vertical J-FET semiconductor arrangement according to Claim 3, **characterized in that** the passivation layer comprises a semiconductor layer which is doped in such a way that it has an opposite conductivity type to that of the first semiconductor region.

6. Vertical J-FET semiconductor arrangement according to one of the preceding claims, **characterized in that** the semiconductor region is fabricated from SiC.

## Revendications

1. Dispositif semi-conducteur J-FET vertical avec une première zone semi-conductrice (2, 3) qui comprend sur sa première surface (4) un premier contact (7) avec couche de contact fortement dopée (8) formant source entre deux deuxièmes contacts (9) formant grille, le premier contact (7) et les deuxièmes contacts (9) étant reliés à chaque fois à une deuxième zone semi-conductrice (5, 6) et la première zone semi-conductrice (2, 3) ainsi que les deuxièmes zones semi-conductrices (5, 6) étant de types de conductivité opposés, **caractérisé par le fait que** celles des deuxièmes zones semi-conductrices (5) qui sont reliées aux deuxièmes contacts (9) s'étendent dans la première zone semi-conductrice (2, 3) au-dessous de celle des deuxièmes zones semi-conductrices (6) qui est reliée au premier contact (7) de telle sorte que les trois deuxièmes zones semi-conductrices (5, 6) se recouvrent au moins partiellement dans une projection sur un plan horizontal et que, dans la première zone semi-conductrice (2, 3), au moins une zone de canal (11) est formée entre les trois deuxièmes zones semi-conductrices (5, 6).

2. Dispositif semi-conducteur J-FET vertical selon la revendication 1, **caractérisé par le fait que** la couche de contact (8) comporte au moins un évidement (14) de telle sorte qu'il existe un contact électrique entre le premier contact (7) et la deuxième zone semi-conductrice (6) au-dessous du premier contact (7).

3. Dispositif semi-conducteur J-FET vertical selon l'une des revendications précédentes, **caractérisé par** une couche de passivation diélectrique à chaque fois entre le premier contact (7) et le deuxième contact (9) sur la surface (4) de la première zone semi-conductrice.

4. Dispositif semi-conducteur J-FET vertical selon la revendication 3, **caractérisé par le fait que** la couche de passivation comprend une couche d'oxyde.

5. Dispositif semi-conducteur J-FET vertical selon la revendication 3, **caractérisé par le fait que** la couche de passivation comprend une couche semi-conductrice qui est dopée de telle sorte qu'elle a un type de conductivité opposé de celui de la première zone semi-conductrice.

6. Dispositif semi-conducteur J-FET vertical selon l'une des revendications précédentes, **caractérisé par le fait que** la zone semi-conductrice est fabriquée en SiC.
